(19) Europäisches Patentamt
European Patent Office
Office européen des brevets

(11) EP 4 382 944 B1

(12) EUROPEAN PATENT SPECIFICATION

(45) Date of publication and mention of the grant of the patent:
**26.08.2026 Bulletin 2026/35**

(21) Application number: **22852663.8**

(22) Date of filing: **07.06.2022**

(51) International Patent Classification (IPC):
***G01R 33/26*** (2006.01) ***G01N 24/00*** (2006.01)
***G01R 33/32*** (2006.01) ***G01N 21/64*** (2006.01)

(52) Cooperative Patent Classification (CPC):
**G01R 33/26; G01N 24/006; G01R 33/323**

(86) International application number:
**PCT/JP2022/022923**

(87) International publication number:
**WO 2023/013235 (09.02.2023 Gazette 2023/06)**

# (54) MEASUREMENT APPARATUS AND MEASUREMENT METHOD USING OPTICALLY DETECTED MAGNETIC RESONANCE

MESSVORRICHTUNG UND MESSVERFAHREN AUF DER BASIS OPTISCH DETEKTIERTER MAGNETRESONANZ

APPAREIL DE MESURE ET PROCÉDÉ DE MESURE UTILISANT LA RÉSONANCE MAGNÉTIQUE DÉTECTÉE OPTIQUEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.08.2021 JP 2021127310**

(43) Date of publication of application:
**12.06.2024 Bulletin 2024/24**

(73) Proprietors:
- **SUMIDA CORPORATION**
  **Tokyo 104-0042 (JP)**
- **Kyoto University**
  **Kyoto-shi, Kyoto 606-8501 (JP)**

(72) Inventors:
- **YOSHII, Yoshiharu**
  **Natori City, Miyagi 9811226 (JP)**
- **MIZUOCHI, Norikazu**
  **Kyoto-shi, Kyoto 606-8501 (JP)**
- **TAKEMURA, Yuki**
  **Kyoto-shi, Kyoto 606-8501 (JP)**

(74) Representative: **Winter, Brandl - Partnerschaft mbB**
**Alois-Steinecker-Straße 22**
**85354 Freising (DE)**

(56) References cited:
**WO-A1-2012/120732** **WO-A1-2016/111363**
**WO-A1-2017/090169** **WO-A1-2021/200144**
**GB-A- 2 580 931** **JP-A- 2004 251 814**
**JP-A- H04 200 533** **JP-A- H05 157 821**
**JP-A- H1 147 113**

- **JAMES L. WEBB: "Nanotesla sensitivity magnetic field sensing using a compact diamond nitrogen-vacancy magnetometer", vol. 114, no. 23, 10 June 2019 (2019-06-10), 2 Huntington Quadrangle, Melville, NY 11747, XP093166292, ISSN: 0003-6951, Retrieved from the Internet <URL:https://pubs.aip.org/aip/apl/article-pdf/doi/10.1063/1.5095241/19767868/231103_1_online.pdf> [retrieved on 20250615], DOI: 10.1063/1.5095241**
- **JEONG HYUN SHIM ET AL: "Multiplexed sensing of magnetic field and temperature in real time using a nitrogen vacancy spin ensemble in diamond", ARXIV.ORG, CORNELL UNIVERSITY LIBRARY, 201 OLIN LIBRARY CORNELL UNIVERSITY ITHACA, NY 14853, 25 April 2021 (2021-04-25), XP081943969**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

### Technical Field

The present invention relates to a measurement apparatus and a measurement method.

### Background Art

A magnetic measurement apparatus performs magnetic measurement with ODMR (Optically Detected Magnetic Resonance) that uses electron spin resonance of a sensing member such as a diamond structure that includes a nitrogen and a lattice defect (an NV center: Nitrogen Vacancy Center). In ODMR, in addition to a measurement target magnetic field, a static magnetic field is applied to a magnetic resonance member such as a diamond that includes such an NV center; laser light (excitation light for initialization and measurement) and microwave are also applied in accordance with a predetermined sequence; and a light intensity is detected of fluorescence emitted from the magnetic resonance member and a magnetic flux density is derived on the basis of the light intensity.

For example, in Ramsey Pulse Sequence, (a) an NV Center is irradiated with excitation light, (b) a first pi/2 pulse of microwave is applied to the NV Center, (c) a second pi/2 pulse of microwave is applied to the NV Center with a predetermined time interval tt from the first pi/2 pulse, (d) the NV Center is irradiated with excitation light, and an emitted light intensity of the NV Center is measured, and (e) a magnetic flux density is derived on the basis of the measured light intensity. Further, in Spin Echo Pulse Sequence, (a) an NV Center is irradiated with excitation light, (b) a first pi/2 pulse of microwave is applied to the NV Center at 0-degree phase of a measurement target magnetic field, (c) a pi pulse of microwave is applied to the NV Center at 180-degree phase of the measurement target magnetic field, (d) a second pi/2 pulse of microwave is applied to the NV Center at 360-degree phase of the measurement target magnetic field, (e) the NV Center is irradiated with excitation light, and an emitted light intensity of the NV Center is measured, and (f) a magnetic flux density is derived on the basis of the measured light intensity.

A sensor device performs magnetic field measurement based on nuclear magnetic resonance using a diamond sensor that includes an NV center as mentioned (see JP 2019 - 138772 A).

Moreover, JAMES L. WEBB wrote a paper about "Nanotesla sensitivity magnetic field sensing using a compact diamond nitrogen-vacancy magnetometer", disclosed in APPLIED PHYSICS LETTERS, [Online], vol. 114, no. 23, on 10 June 2019 (2019-06-10), XP093166292, 2 Huntington Quadrangle, Melville, NY 11747; ISSN: 0003-6951, DOI: 10.1063/1.5095241. In this article, a portable diamond NV magnetic field sensor is disclosed, in which a fluorescence collection using an optical fitter and diode in contact with a diamond is used.

### Summary of invention

Optically Detected Magnetic Resonance based on an electron spin resonance of a sensing member is easily affected by noise because of a weak detection signal obtained from fluorescence, and in particular, noise in an irradiation light (laser light) causes low measurement accuracy.

The present invention has been conceived in view of the aforementioned problem. It is an object of the present invention to obtain a measurement apparatus and a measurement method that reduce a noise component due to irradiation light and thereby get high measurement accuracy. The invention is set out in the appended set of claims.

A measurement apparatus according to the present invention includes: a magnetic resonance member of which an electron spin quantum state is changed correspondingly to a measurement target field, the a magnetic resonance member capable of an electron spin quantum operation with microwave; a high-frequency magnetic field generator that is configured to perform the electron spin quantum operation of the magnetic resonance member with the microwave; a light emitting device that is configured to emit excitation light with which the magnetic resonance member should be irradiated; a fluorescence light receiving device that is configured to receive fluorescence emitted by the magnetic resonance member correspondingly to the excitation light and that is configured to generate a fluorescence sensor signal corresponding to an intensity of the fluorescence; a CMR calculation unit that is configured to perform for the fluorescence sensor signal common mode rejection based on a reference sensor signal generated by receiving a reference light obtained as a branch of the excitation light, and is configured to generate a CMR signal based on the common mode rejection; a first analog-digital converter that is configured to digitize the CMR signal; a second analog-digital converter that is configured to digitize a reference light sensor signal generated by receiving a reference light obtained as a branch of the excitation light; and a processor that is configured to divide the digitized CMR signal by the digitized reference light sensor signal and thereby is configured to generate a detection signal, and is configured to derive a measurement value of the measurement target field on the basis of the detection signal. Further, the processor is configured to perform a noise-removal digital filter process for the digitized CMR signal or the detection signal.

A measurement method according to the present invention includes the steps of: performing an electron spin

quantum operation of magnetic resonance member with microwave and emitting excitation light to the magnetic resonance member in accordance with a predetermined measurement sequence, the magnetic resonance member of which an electron spin quantum state is changed correspondingly to a measurement target field and capable of electron spin quantum operation with microwave; receiving fluorescence emitted by the magnetic resonance member correspondingly to the excitation light, and generating a fluorescence sensor signal corresponding to an intensity of the fluorescence; performing for the fluorescence sensor signal common mode rejection based on a reference sensor signal generated by receiving a reference light obtained as a branch of the excitation light, and generating a CMR signal based on the common mode rejection; digitizing the CMR signal; digitizing a reference light sensor signal generated by receiving reference light obtained as a branch of the excitation light; and dividing the digitized CMR signal by the digitized reference light sensor signal and thereby generating a detection signal, and deriving a measurement value of the measurement target field on the basis of the detection signal. Further, a noise-removal digital filter process is performed for the digitized CMR signal or the detection signal. Advantageous effect of invention

By means of the present invention, obtained are a measurement apparatus and a measurement method that reduce a noise component due to irradiation light and thereby get high measurement accuracy.

Brief description of drawings

Fig. 1 shows a block diagram that indicates a configuration of a measurement apparatus according to an embodiment of the present invention;
Fig. 2 shows a diagram that indicates an example of a measurement sequence;
Fig. 3 shows a diagram that explains reference light sensor signals ref1(t), ref2(t), a fluorescence sensor signal PL(t), a CMR signal CMR_SIG(t), and a detection signal SD(t);
Fig. 4 shows a diagram that indicates an example of a frequency characteristic of a window function; and
Fig. 5 shows a flowchart that explains a behavior of the measurement apparatus (i.e. a measurement method) according to the embodiment shown in Fig. 1.

Description of embodiments

Hereinafter, an embodiment according to aspects of the present invention will be explained with reference to a drawing.

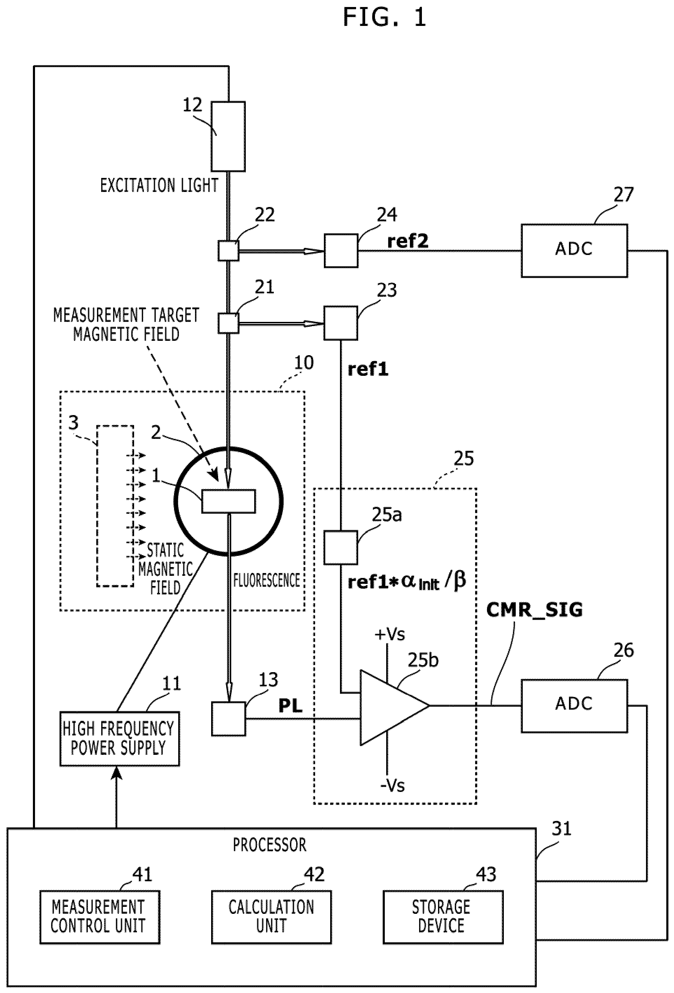

Fig. 1 shows a block diagram that indicates a configuration of a measurement apparatus according to an embodiment of the present invention. The measurement apparatus shown in Fig. 1 includes a sensor unit 10, a high-frequency power supply 11, a light emitting device 12, and a light receiving device 13.

The sensor unit 10 detects a measurement target field (e.g. a magnetic field such as an intensity, a direction, and/or the like of it) at a predetermined position (e.g. on or over a surface of a test target object). The measurement target field may be an AC (Alternating Current) field of a single frequency, an AC field that includes plural frequency components and has a predetermined period, or a DC (Direct Current) field.

In this embodiment, the sensor unit 10 includes a magnetic resonance member 1, a high-frequency magnetic field generator 2, and a magnet 3; and detects the measurement target field using ODMR.

The magnetic resonance member 1 includes a crystal structure, and is a member of which an electron spin quantum state is changed correspondingly to the measurement target field (here, magnetic field) and capable of electron spin quantum operations (based on Rabi oscillation) with microwave of frequencies corresponding to arrangement orientations of a vacancy and an impurity in a crystal lattice. Therefore, at a measurement position of the magnetic field, the magnetic resonance member 1 is arranged.

In this embodiment, the magnetic resonance member 1 is an optically detected magnetic resonance member that includes plural specific color centers (i.e. color center ensemble). Each of the plural specific color centers has a Zeeman-splittable energy level and can take plural orientations of which energy level shift amounts due to Zeeman splitting are different from each other.

Here the magnetic resonance member 1 is a member such as a diamond including plural NV (Nitrogen Vacancy) centers as specific color centers of a single type. In the NV center, the ground level is a triplet level of Ms = 0, +1, -1, and levels of Ms = +1 and Ms = -1 are Zeeman-splittable. When the NV centers make transitions from excitation states of levels of Ms = +1 and Ms = -1 to the ground level, a predetermined percentage of the NV centers is accompanied by fluorescence, and a remaining percentage of the NV centers makes a radiationless transition from the excitation state (Ms = +1 or Ms = -1 ) to the ground level (Ms = 0).

It should be noted that color centers included in the magnetic resonance member 1 may be color centers other than NV centers.

The high-frequency magnetic field generator 2 applies microwave to the magnetic resonance member 1 and thereby performs an electron spin quantum operation of the magnetic resonance member 1. For example, the high-frequency magnetic field generator 2 is a plate coil, and includes a coil part of a substantially circular shape that outputs microwave, and terminal parts that extend from both ends of the coil part and are fixed to a substrate. The high-frequency power supply 11 generates a current for the microwave, and causes the high-frequency magnetic field generator 2 to conduct the current. This coil part conducts two flows of current parallel to each other with a predetermined gap on its both end surfaces such that the magnetic resonance member 1 is arranged between the two flows, and thereby outputs the aforementioned microwave. Here, although the coil part is a plate coil, the current flows in end surface parts of the coil part due to skin effect, and thereby the two flows of the current are formed.

In case of NV center, a color center is formed of a vacancy (hole) (V) and a nitrogen (N) as impurity in a diamond crystal, there are four possible positions (arrangement orientations of the vacancy and the nitrogen) of the nitrogen (N) adjacent to the vacancy (hole) (V) in the diamond crystal, and sub energy levels after Zeeman splitting (i.e. energy levels away from the base energy level) corresponding to these positions (i.e. four arrangement orientation) are different from each other. Therefore, in a characteristic of fluorescence intensities to frequencies of the microwave after Zeeman splitting due to the static magnetic field, four dip frequency pairs (fi+, fi-) corresponding to the orientations i (i = 1, 2, 3, 4) appear differently from each other. Here, a frequency (a wavelength) of the aforementioned microwave is set correspondingly to any dip frequency among the four dip frequency pairs.

Further, the magnet 3 applies a static magnetic field (DC magnetic field) and thereby causes Zeeman splitting of the energy level of the plural specific color centers (here, plural NV centers) in the magnetic resonance member 1. Here, the magnet 3 is a ring-type permanent magnet, for example, a ferrite magnet, an alnico magnet, a samarium-cobalt magnet or the like.

In this embodiment, an application direction of the aforementioned static magnetic field is identical to an application direction of the aforementioned measurement target magnetic field, and applying the aforementioned static magnetic field gains fluorescence intensity variation at the aforementioned dip frequency and results in a high sensitivity.

Further, in this embodiment, the magnetic resonance member 1 includes plural color centers (here, NV centers) capable of electron spin quantum operations with the aforementioned microwave, and the magnet 3 applies a substantially uniform static magnetic field to a predetermined area (an irradiation area of the excitation light and the measurement light) of the magnetic resonance member 1. For example, the static magnetic field is applied such that in the predetermined area a difference or a ratio between a maximum value and a minimum value of intensity of the static magnetic field gets equal to or less than a predetermined value.

Further, a crystal in the magnetic resonance member 1 is formed and an orientation of the magnetic resonance member 1 is set, so as to cause an arrangement direction of the aforementioned vacancy and impurity to be substantially identical to a direction of the aforementioned static magnetic field (and a direction of the application magnetic field) in the magnetic resonance member 1.

Further, in this embodiment, in order to irradiate the magnetic resonance member 1 with the excitation light, an optical system from the light emitting device 12 to the magnetic resonance member 1 is installed and an optical system from the magnetic resonance member 1 to the light receiving device 13 is installed.

The light emitting device 12 includes a laser diode as a light source and using the light source, emits laser light of a predetermined wavelength as excitation light with which the magnetic resonance member 1 should be irradiated. Further, the light receiving device 13 includes a photo diode or photo transistor as photodetector, and receives fluorescence emitted by the magnetic resonance member 1 correspondingly to the excitation light and generates a fluorescence sensor signal PL corresponding to an intensity of the fluorescence. This fluorescence is converged toward the light receiving device 13 by an optical system such as compound paraboloid type condenser (CPC), for example.

Here a principle of the measurement is explained.

An intensity I of the aforementioned excitation light is a sum of an original intensity Ilaser and an intensity of a noise component Inoise, as the following formula. This noise component occurs due to a fluctuation of a power supply voltage of the light emitting device 12, a fluctuation of a light emitting amount of the light source or the like, and has a frequency in a range from about kHz-order frequency to about 100kHz-order frequency, for example.

$$I = Ilaser + Inoise$$

Further, a level of the fluorescence sensor signal PL is basically proportional to the intensity I of the excitation light. However, at an excitation light irradiation starting time point of the measurement, the fluorescence intensity is small due to change of an electron spin quantum state by a measurement target field, and after it, the fluorescence intensity gradually increases until influence disappears of the change of the electron spin quantum state by the measurement target field. Therefore, a detection signal SD is derived as a signal that indicates the measurement target field such that the detection signal SD is proportional to a level change component $\alpha$cont(t) of the fluorescence sensor signal PL due to the change of the electron spin quantum state by the measurement target field. The fluorescence sensor signal PL is

expressed as the following formula.

$$PL(t) = \alpha(t) \times I = (\alpha init + \alpha cont(t)) \times I = (\alpha init + \alpha cont(t)) \times (Ilaser + Inoise)$$

Here, $\alpha$init is a coefficient that indicates a component proportional to the intensity I of the excitation light (a component without influence of the change of the electron spin quantum state by the measurement target field).

Meanwhile, a level ref of a reference light sensor signal of reference light as a branch of the excitation light is proportional to the intensity I of the excitation light, and therefore expressed as the following formula.

$$ref = ref1 = ref2 = \beta \times I = \beta \times (Ilaser + Inoise)$$

Here, $\beta$ is a constant. ref1 and ref2 are mentioned below.

Here, common mode rejection is performed for PL(t) and thereby a CMR signal is generated. The CMR signal CMR_SIG(t) is expressed as the following formula. Consequently, regarding $\alpha$init, influence of Inoise is eliminated.

$$CMR_SIG(t) = PL(t) - \alpha init / \beta \times ref(t) = \alpha cont(t) \times (Ilaser + Inoise)$$

Further, the aforementioned detection signal SD(t) is derived as the following formula. Consequently, regarding $\alpha$cont(t), influence of Inoise is eliminated.

$$SD(t) = \alpha cont(t) / \beta = CMR_SIG(t) / ref(t)$$

A peak value (a value at t=0) and a time-integral value of the detection signal SD(t) have correlations with an intensity of the measurement target field, and therefore, a relationship between a peak value or a time-integral value of the detection signal SD(t) and an intensity of the measurement target field is determined by an experiment or the like in advance, and an intensity of the measurement target field is derived from a peak value or a time-integral value of the detection signal SD(t) using a calculation formula or a table that indicates the relationship.

A configuration mentioned below is installed on the basis of the aforementioned measurement principle.

The measurement apparatus shown in Fig. 1 further includes light separation units 21 and 22 as optical elements on a light path of the excitation light from the light emitting device 12 to the magnetic resonance member 1. The light separation units 21 and 22 make respective branches of the excitation light as parts of the excitation light, and emit the parts of the excitation light as reference light to other directions, respectively. For example, the light separation units 21 and 22 are polarization-independent beam splitters.

Further, the measurement device shown in Fig. 1 includes light receiving devices 23 and 24 that receive the reference light and generate reference light sensor signals ref1 and ref2 (the aforementioned ref) corresponding to an intensity of the reference light.

In this embodiment, two flows of the reference light are independently generated from the excitation light, and two reference light sensor signals ref1 and ref2 are generated. The reference light sensor signal ref1 is used in the common mode rejection mentioned below, and the reference light sensor signal ref2 is digitized and used to generate the detection signal SD.

Further, the measurement apparatus shown in Fig. 1 includes a CMR calculation unit 25 as an analog calculation circuit. The CMR calculation unit 25 performs for the fluorescence sensor signal PL common mode rejection based on the reference sensor signal ref1, and generates a CMR signal CMR_SIG based on the common mode rejection. Specifically, the CMR calculation unit 25 includes a coefficient unit 25a and a differential amplifier 25b. The coefficient unit 25a multiplies the reference light sensor signal ref 1 by a predetermined coefficient $\alpha$init/$\beta$. The differential amplifier 25b calculates a difference between the fluorescence sensor signal PL and an output signal ref1 × □init/$\beta$ of the coefficient unit 25a, and outputs the calculation result as the CMR signal CMR_SIG.

The coefficient unit 25a may be installed as a circuit, and otherwise, the coefficient unit 25a may not be installed and a gain of the light receiving device 23 may be controlled and thereby may output the reference light sensor signal multiplied by the predetermined coefficient $\alpha$init/$\beta$.

Further, the measurement apparatus shown in Fig. 1 includes analog-digital converters 26 and 27 that digitize the CMR signal CMR_SIG and the reference light sensor signal ref2, respectively; and a processor 31 that controls the measurement apparatus and performs signal processing.

The analog-digital converters 26 and 27 digitize the CMR signal CMR_SIG and the reference light sensor signal ref2 with predetermined bit widths and with predetermined sampling periods (rates), and outputs the digitized CMR signal CMR_SIG and the digitized reference light sensor signal ref2 to the processor 31.

The processor 31 includes a computer, for example, and executes a signal processing program using the computer, and thereby acts as sorts of processing units. In this embodiment, the processor 31 causes the computer to act as a measurement control unit 41 and a calculation unit 42, and includes a nonvolatile storage device 43.

In the storage device 43, the signal processing program has been stored, and the computer includes a CPU (Central Processing Unit), a ROM (Read Only Memory), a RAM (Random Access Memory) and the like, and loads the signal processing program to the RAM and executes the signal processing program using the CPU, and thereby acts as the measurement control unit 41 and the calculation unit 42.

In accordance with a predetermined measurement sequence, the measurement control unit 41 (a) controls the high-frequency power supply 11 and the light emitting device 12, and (b) acquires the aforementioned digitized CMR signal CMR_SIG and reference light sensor signal ref2 and stores CMR_SIG and ref 2 into the RAM or the storage device 43 and causes the calculation unit 42 to derive a measurement value of the measurement target field.

The aforementioned measurement sequence is set in accordance with a frequency or the like of the measurement target field. For example, if the measurement target field is an AC (alternating current) field of a relatively high frequency, a Spin Echo sequence (Hahn Echo sequence) is applied as this measurement sequence. The measurement sequence is not limited to this. Further, for example, if the measurement field is an AC field of a relatively low frequency, measurement of the physical field may be performed plural times in one period of the measurement target field in accordance with Ramsey pulse sequence (i.e. a measurement sequence for a DC (Direct Current) field), and the measurement target field (intensities, waveform or the like of it) may be determined on the basis of measurement results.

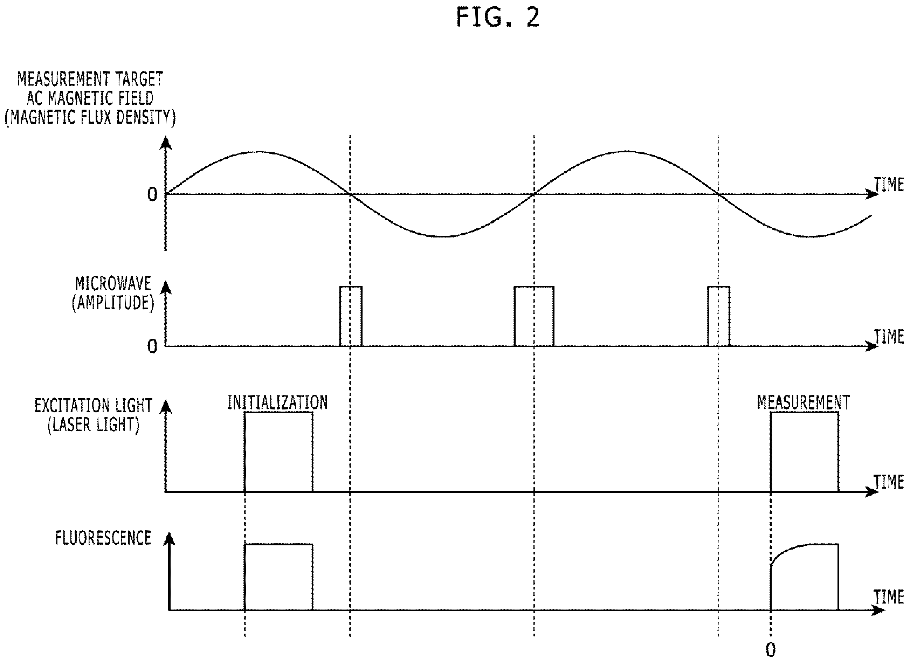

Fig. 2 shows a diagram that indicates an example of a measurement sequence. Fig. 2 indicates timings of microwave pulses and irradiation timings of the excitation light (twice for initialization and measurement) for the measurement target magnetic field in Spin Echo sequence. As shown in Fig. 2, fluorescence is detected in an irradiation period of the excitation light.

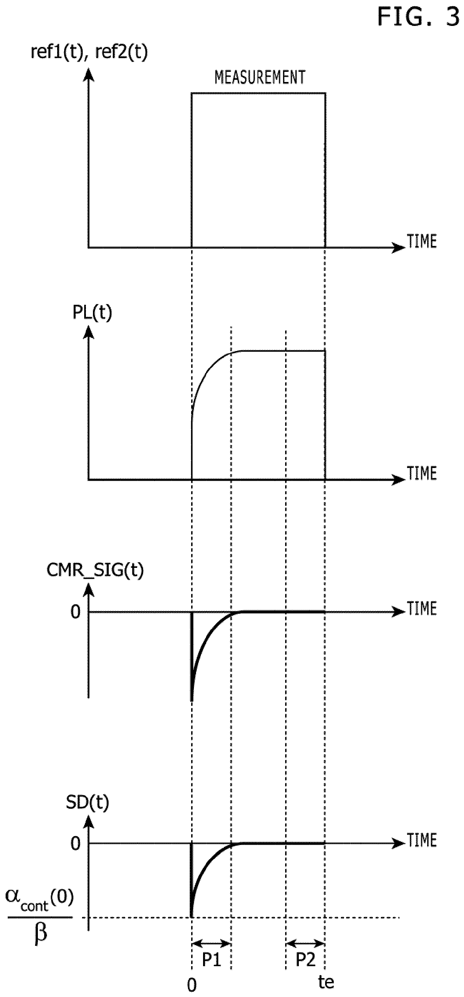

Fig. 3 shows a diagram that explains reference light sensor signals ref1(t), ref2(t), a fluorescence sensor signal PL(t), a CMR signal CMR_SIG(t), and a detection signal SD(t).

As shown in Fig. 3, the reference light sensor signals ref1(t) and ref2(t) are pulse signals of a substantially square shape in the irradiation period, and the fluorescence sensor signal PL(t) is a pulse signal that gradually raises and converges to a constant level in the irradiation period. Further, the CMR signal CMR_SIG(t) is obtained by the common mode rejection.

Further, the calculation unit 42 divides the digitized CMR signal CMR_SIG(t) by the digitized reference light sensor signal ref2(t) and thereby generates the detection signal SD(t) proportional to $\alpha$cont(t), and derives a measurement value (here, a magnetic flux density, a waveform of the magnetic field or the like) of the measurement target field on the basis of the detection signal SD(t).

Furthermore, the calculation unit 42 performs a noise-removal digital filter process for the digitized CMR signal CMR_SIG(t) or the detection signal SD(t).

In this embodiment, in this digital filter process, the calculation unit 42 applies a window function to the digitized CMR signal CMR_SIG(t) or the detection signal SD(t), and thereby reduces a high frequency component (a noise component having a high frequency) in this signal. The window function is a FIR (Finite Impulse Response) filter.

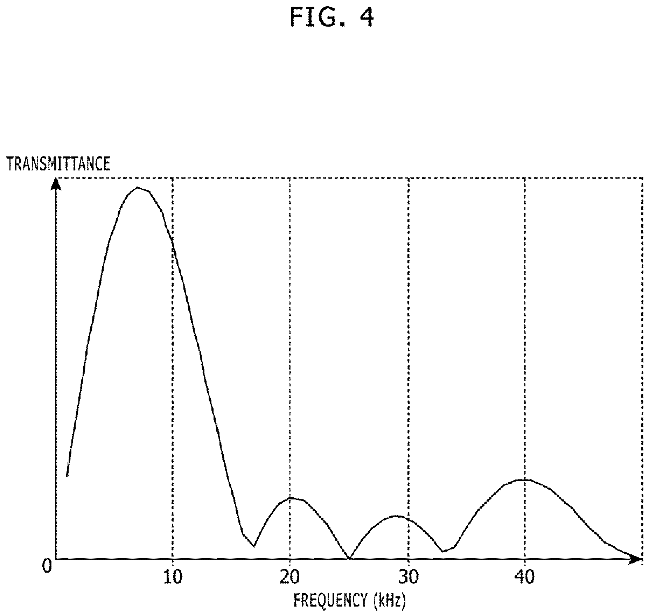

Fig. 4 shows a diagram that indicates an example of a frequency characteristic of a window function. The aforementioned window function has a frequency characteristic as shown in Fig. 4, for example, and reduces a high frequency noise component (in this case, reduces a component of about 10 kHz or higher).

Further, in this embodiment, the calculation unit 42 performs a noise removal process independently from the aforementioned digital filter process. In the noise removal process, the calculation unit 42 (a) accumulates values of the digitized CMR signal (of a predetermined sampling number) obtained plural times in a first half part of an irradiation period of the excitation light and plural times in a second half part of the irradiation period, and (b) calculates a difference between an accumulation value (a total sum or an average) of the CMR signal in the first half part and an accumulation value (a total sum or an average) of the CMR signal in the second half part and thereby removes a noise component in the CMR signal.

As shown in Fig. 3, for example, in a period P1 (a period of a predetermined time length from an irradiation staring time point (t=0)) in the first half part, values of the CMR signal of a predetermined sampling number are obtained; in a period P2 (a period of a predetermined time length to an irradiation ending time point (t=te)) in the second half part, values of the CMR signal of the predetermined sampling number are obtained; and the accumulation value of the second half part is subtracted from the accumulation value of the first half part, a value of the subtraction result is set as a value of the CMR signal and thereby a noise component in the CMR signal is restrained.

Further, in this embodiment, the analog-digital converter 26 operates at a higher rate than the analog-digital converter 27, and the analog-digital converter 27 performs digitization of a higher precision than the analog-digital converter 26.

For example, the analog-digital converter 26 converts an input analog signal to a 20-bit digital signal with 200M samples per second, for example; and the analog-digital converter 27 converts an input analog signal to a 24-bit digital signal with 100k samples per second, for example.

The CMR signal after analog-digital conversion by the analog-digital converter 26 changes relatively quickly and therefore is sampled by the high-rate analog-digital converter 26, and as mentioned, the noise removal based on plural times of sampling is performed. On the other hand, as mentioned, the reference light sensor signal ref2 after analog-digital conversion by the analog-digital converter 27 is used for the dividing for theoretically removing influence of the noise component Inoise in the excitation light, and requires a precision corresponding to a voltage level of the term of the product of the level change component $\alpha$cont(t) and the noise component intensity Inoise, relative to a voltage level of the fluorescence sensor signal PL in the detected fluorescence sensor signal PL, and therefore, the reference light sensor signal ref2 is sampled by the relatively-high-precision analog-digital converter 27.

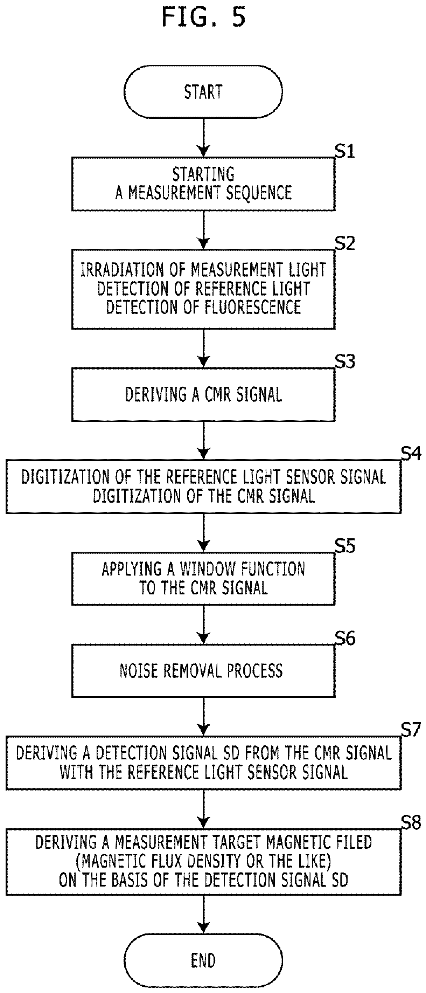

The following part explains a behavior of the measurement apparatus in this embodiment. Fig. 5 shows a flowchart that explains a behavior of the measurement apparatus (i.e. a measurement method) according to the embodiment shown in Fig. 1.

The sensor unit 10 is arranged at a measurement position of a measurement target field. The measurement may be performed at plural measurement positions while the sensor unit is moved for scanning.

Subsequently, the measurement control unit 41 causes the light emitting device 12 to emit excitation light and causes the high-frequency magnetic field generator 2 to output microwave, in accordance with a predetermined measurement sequence (in Step S1).

Consequently, in an irradiation period of the excitation light in the measurement, the fluorescence sensor signal PL (analog signal) is outputted from the light receiving device 13, and the reference light sensor signals ref1 and ref2 (analog signal) are outputted from the light receiving devices 23 and 24, respectively (in Step S2). Subsequently, the CMR signal CMR_SIG(t) based on the fluorescence sensor signal PL(t) and the reference light sensor signal ref1 is outputted by the CMR calculation unit 25, and digitized by the analog-digital converter 26 (in Steps S3 and S4). On the other hand, the reference light sensor signal ref2 is digitized by the analog-digital converter 27 (in Step S4).

When the measurement control unit 41 acquires the CMR signal CMR_SIG(t) (digital signal) and the reference light sensor signal ref2 (digital signal), the calculation unit 42 applies the window function to the CMR signal and thereby removes a high-frequency noise component (e.g. a component of 10kHz or higher) in the CMR signal CMR_SIG(t) (in Step S5), and further performs the accumulation and the subtraction of plural-times (e.g. 1000-times) sampled values of the CMR signal CMR_SIG(t) and thereby removes a noise component of a relatively low frequency (e.g. a component of a few kHz to 10kHz) (in Step S6).

Subsequently, the calculation unit 42 divides a value of the CMR signal obtained after the noise removal as mentioned, by a value of the reference light sensor signal ref2, and thereby derives a value of the detection signal (in Step S7), and derives a measurement value of the measurement target field at the measurement position and at the measurement timing (at a performing timing of the measurement sequence) from the value of the detection signal (in Step S7).

As mentioned, in the aforementioned embodiment, the high-frequency magnetic field generator 2 performs with microwave an electron spin quantum operation of the magnetic resonance member 1 of which an electron spin quantum state is changed correspondingly to a measurement target field and capable of an electron spin quantum operation with microwave. The light emitting device 12 emits excitation light with which the magnetic resonance member 1 should be irradiated. The light receiving device 13 receives fluorescence emitted by the magnetic resonance member 1 correspondingly to the excitation light and generates a fluorescence sensor signal corresponding to an intensity of the fluorescence. For the fluorescence sensor signal, the CMR calculation unit 25 performs common mode rejection based on a reference sensor signal generated by receiving a reference light obtained as a branch of the excitation light, and generates a CMR signal based on the common mode rejection. The analog-digital converter 26 digitizes the CMR signal and the analog-digital converter 27 digitizes a reference light sensor signal generated by receiving a reference light obtained as a branch of the aforementioned excitation light. The processor 31 divides the digitized CMR signal by the digitized reference light sensor signal and thereby generates a detection signal, and derives a measurement value of the measurement target field on the basis of the detection signal. Further, the processor 31 performs a noise-removal digital filter process for the digitized CMR signal or the detection signal.

Consequently, the aforementioned common mode rejection, the dividing, and the digital filter process restrain a noise component due to the excitation light with which the magnetic resonance member 1 is irradiated, and therefore increase measurement precision.

Further, it should be understood that various changes and modifications to the embodiments described herein will be apparent to those skilled in the art.

For example, in the aforementioned embodiment, the magnetic field measurement is performed on the basis of Optically Detected Magnetic Resonance. Alternatively, temperature measurement or the like may be performed as well. In addition, a current measurement may be performed on the basis of a magnetic field obtained by the magnetic measurement.

Further, in the aforementioned embodiment, the reference light for the aforementioned dividing is made as a branch of the excitation light independently from the reference light for the common mode rejection. Alternatively, the

reference light made as a branch of the excitation light for the common mode rejection may be used as the reference light for the aforementioned dividing. Furthermore, the aforementioned reference light sensor signals ref1 and ref2 are generated independently from each other. Alternatively, a single reference light sensor signal ref may be generated and used as the aforementioned reference light sensor signals ref1 and ref2.

Furthermore, in the aforementioned embodiment, the window function is applied to the CMR signal. Alternatively, the window function may be applied to the detection signal.

Furthermore, in the aforementioned embodiment, the differential amplifier 235b may be installed independently from the analog-digital converter 26 or may be built in the analog-digital converter 26.

Industrial applicability

For example, the present invention is applicable to a measurement apparatus using Optically Detected Magnetic Resonance.

## Claims

**1.** A measurement apparatus, comprising:

a magnetic resonance member (1) of which an electron spin quantum state is changed correspondingly to a measurement target field, the magnetic resonance member capable of an electron spin quantum operation with microwave;
a high-frequency magnetic field generator (2) that is configured to perform the electron spin quantum operation of the magnetic resonance member with the microwave;
a light emitting device (12) that is configured to emit excitation light with which the magnetic resonance member should be irradiated;
a fluorescence light receiving device (13) that is configured to receive fluorescence emitted by the magnetic resonance member correspondingly to the excitation light and is configured to generate a fluorescence sensor signal corresponding to an intensity of the fluorescence; and
a CMR calculation unit (25) that is configured to perform for the fluorescence sensor signal common mode rejection based on a reference sensor signal generated by receiving a reference light obtained as a branch of the excitation light, and is configured to generate a CMR signal based on the common mode rejection;
a first analog-digital converter (26) that is configured to digitize the CMR signal;
**characterized in that** the measurement apparatus further comprising:

a second analog-digital converter (27) that is configured to digitize a reference light sensor signal generated by receiving a reference light obtained as a branch of the excitation light; and
a processor (31) that is configured to divide the digitized CMR signal by the digitized reference light sensor signal and thereby is configured to generate a detection signal, and is configured to derive a measurement value of the measurement target field on the basis of the detection signal;
wherein the processor is configured to perform a noise-removal digital filter process for the digitized CMR signal or the detection signal.

**2.** A measurement method, comprising the steps of:

performing an electron spin quantum operation of magnetic resonance member (1) with microwave and emitting excitation light to the magnetic resonance member in accordance with a predetermined measurement sequence, the magnetic resonance member of which an electron spin quantum state is changed correspondingly to a measurement target field and capable of electron spin quantum operation with microwave;
receiving fluorescence emitted by the magnetic resonance member correspondingly to the excitation light, and generating a fluorescence sensor signal corresponding to an intensity of the fluorescence;
performing for the fluorescence sensor signal common mode rejection based on a reference sensor signal generated by receiving a reference light obtained as a branch of the excitation light, and generating a CMR signal based on the common mode rejection;
digitizing the CMR signal;
digitizing a reference light sensor signal generated by receiving reference light obtained as a branch of the excitation light;
dividing the digitized CMR signal by the digitized reference light sensor signal and thereby generating a detection

signal, and deriving a measurement value of the measurement target field on the basis of the detection signal; and performing a noise-removal digital filter process for the digitized CMR signal or the detection signal.

3. The measurement method according to claim 2, wherein the CMR signal is digitized by a first analog-digital converter (26);

   the reference light sensor signal is digitized by a second analog-digital converter (27);
   the first analog-digital converter operates at a higher rate than the second analog-digital converter; and
   the second analog-digital converter performs digitization of a higher precision than the first analog-digital converter.

4. The measurement method according to claim 2, wherein the reference light sensor signal digitized and used for generation of the detection light is generated independently from the reference light sensor signal used for the common mode rejection.

5. The measurement method according to claim 2, wherein in the digital filer process, a window function is applied to the digitized CMR signal or the detection signal.

6. The measurement method according to claim 2, further comprising the steps of:

   (a) accumulating values of the digitized CMR signal obtained plural times in a first half part of an irradiation period of the excitation light and plural times in a second half part of the irradiation period; and
   (b) calculating a difference between an accumulation value of the CMR signal in the first half part and an accumulation value of the CMR signal in the second half part and thereby removing a noise component in the CMR signal.

## Patentansprüche

1. Messapparat, der aufweist:

   ein Magnetresonanzglied (1), dessen Elektronenspin-Quantenzustand entsprechend einem Messzielfeld geändert wird, wobei das Magnetresonanzglied zu einem Elektronenspin-Quantenvorgang mit Mikrowellen fähig ist;
   einen Hochfrequenz-Magnetfeldgenerator (2), der konfiguriert ist, um den Elektronenspin-Quantenvorgang des Magnetresonanzglieds mit den Mikrowellen durchzuführen;
   eine lichtemittierende Vorrichtung (12), die konfiguriert ist, um Anregungslicht zu emittieren, mit dem das Magnetresonanzglied bestrahlt werden sollte;
   eine Fluoreszenzlicht-Empfangsvorrichtung (13), die konfiguriert ist, um eine Fluoreszenz, die von dem Magnetresonanzglied entsprechend dem Anregungslicht emittiert wird, zu empfangen, und konfiguriert ist, um ein Fluoreszenzsensorsignal entsprechend einer Intensität der Fluoreszenz zu erzeugen; und
   eine CMR-Berechnungseinheit (25), die konfiguriert ist, um für das Fluoreszenzsensorsignal eine Gleichtaktunterdrückung basierend auf einem Referenzsensorsignal, das durch Empfangen eines Referenzlichts erzeugt wird, das als eine Abzweigung des Anregungslichts erhalten wird, durchzuführen, und konfiguriert ist, um ein CMR-Signal basierend auf der Gleichtaktunterdrückung zu erzeugen;
   einen ersten Analog-Digital-Wandler (26), der konfiguriert ist, um das CMR-Signal zu digitalisieren;
   **dadurch gekennzeichnet, dass** der Messapparat des Weiteren aufweist:

      einen zweiten Analog-Digital-Wandler (27), der konfiguriert ist, um ein Referenzlicht-Sensorsignal, das durch Empfangen eines Referenzlichts erzeugt wird, das als eine Abzweigung des Anregungslichts erhalten wird, zu digitalisieren; und
      einen Prozessor (31), der konfiguriert ist, um das digitalisierte CMR-Signal durch das digitalisierte Referenzlicht-Sensorsignal zu teilen, und dadurch konfiguriert ist, um ein Detektionssignal zu erzeugen, und konfiguriert ist, um einen Messwert des Messzielfelds auf der Basis des Detektionssignals abzuleiten;
      wobei der Prozessor konfiguriert ist, um einen Rauschentfernungs-Digitalfilterprozess für das digitalisierte CMR-Signal oder das Detektionssignal durchzuführen.

2. Messverfahren, das die folgenden Schritte aufweist:

ein Durchführen eines Elektronenspin-Quantenvorgangs eines Magnetresonanzglieds (1) mit Mikrowellen und ein Emittieren von Anregungslicht zu dem Magnetresonanzglied gemäß einer vorbestimmten Messsequenz, wobei das Magnetresonanzglied, dessen Elektronenspin-Quantenzustand entsprechend einem Messzielfeld geändert wird, zu einem Elektronenspin-Quantenvorgang mit Mikrowellen fähig ist;
ein Empfangen einer Fluoreszenz, die von dem Magnetresonanzglied entsprechend dem Anregungslicht emittiert wird, und ein Erzeugen eines Fluoreszenzsensorsignals entsprechend einer Intensität der Fluoreszenz;
ein Durchführen einer Gleichtaktunterdrückung für das Fluoreszenzsensorsignal basierend auf einem Referenzsensorsignal, das durch Empfangen eines Referenzlichts erzeugt wird, das als eine Abzweigung des Anregungslichts erhalten wird, und ein Erzeugen eines CMR-Signals basierend auf der Gleichtaktunterdrückung;
ein Digitalisieren des CMR-Signals;
ein Digitalisieren eines Referenzlicht-Sensorsignals, das durch Empfangen eines Referenzlichts erzeugt wird, das als eine Abzweigung des Anregungslichts erhalten wird;
ein Teilen des digitalisierten CMR-Signals durch das digitalisierte Referenzlicht-Sensorsignal und dadurch ein Erzeugen eines Detektionssignals, und ein Ableiten eines Messwerts des Messzielfelds auf der Basis des Detektionssignals; und
ein Durchführen eines Rauschentfernungs-Digitalfilterprozesses für das digitalisierte CMR-Signal oder das Detektionssignal.

**3.** Messverfahren nach Anspruch 2, wobei das CMR-Signal durch einen ersten Analog-Digital-Wandler (26) digitalisiert wird;

das Referenzlicht-Sensorsignal durch einen zweiten Analog-Digital-Wandler (27) digitalisiert wird;
der erste Analog-Digital-Wandler mit einer höheren Rate als der zweite Analog-Digital-Wandler tätig ist; und
der zweite Analog-Digital-Wandler eine Digitalisierung mit einer höheren Präzision als der erste Analog-Digital-Wandler durchführt.

**4.** Messverfahren nach Anspruch 2, wobei das Referenzlicht-Sensorsignal, das digitalisiert und zur Erzeugung des Detektionslichts verwendet wird, unabhängig von dem Referenzlicht-Sensorsignal, das für die Gleichtaktunterdrückung verwendet wird, erzeugt wird.

**5.** Messverfahren nach Anspruch 2, wobei in dem Digitalfilterprozess eine Fensterfunktion auf das digitalisierte CMR-Signal oder das Detektionssignal angewendet wird.

**6.** Messverfahren nach Anspruch 2, das des Weiteren die folgenden Schritte aufweist:

(a) ein Akkumulieren von Werten des digitalisierten CMR-Signals, die mehrmals in einem ersten Halbteil eines Bestrahlungszeitabschnitts des Anregungslichts und mehrmals in einem zweiten Halbteil des Bestrahlungszeitabschnitts erhalten werden; und
(b) ein Berechnen einer Differenz zwischen einem Akkumulationswert des CMR-Signals in dem ersten Halbteil und einem Akkumulationswert des CMR-Signals in dem zweiten Halbteil und dadurch ein Entfernen einer Rauschkomponente in dem CMR-Signal.

## Revendications

**1.** Appareil de mesure, comprenant :

un membre de résonance magnétique (1) dont un état quantique de spin électronique est modifié en fonction d’un champ cible de mesure, le membre de résonance magnétique capable d’une opération quantique de spin électronique avec micro-ondes ;
un générateur de champ magnétique haute fréquence (2) configuré pour effectuer l’opération quantique de spin électronique de l’élément de résonance magnétique avec les micro-ondes ;
un dispositif émetteur de lumière (12) qui est configuré pour émettre une lumière d’excitation avec laquelle l’élément de résonance magnétique doit être irradié ;
un dispositif de réception de lumière de fluorescence (13) qui est configuré pour recevoir la fluorescence émise par l’élément de résonance magnétique en correspondance avec la lumière d’excitation et configuré pour générer un signal de capteur de fluorescence correspondant à une intensité de fluorescence ; et

une unité de calcul CMR (25) qui est configurée pour effectuer une réjection en mode commun du signal du capteur de fluorescence à partir d'un signal de capteur de référence généré par la réception d'une lumière de référence obtenue à partir d'une partie de la lumière d'excitation, et qui est configuré pour générer un signal CMR à partir de cette réjection en mode commun ;
un premier convertisseur analogique-numérique (26) qui est configuré pour numériser le signal CMR ;
**caractérisé en ce que** l'appareil de mesure comprend en outre :

un second convertisseur analogique-numérique (27) qui est configuré pour numériser un signal de capteur de lumière de référence généré par la réception d'une lumière de référence obtenue comme une branche de la lumière d'excitation ; et
un processeur (31) qui est configuré pour diviser le signal CMR numérisé par le signal du capteur de lumière de référence numérisé et est ainsi configuré pour générer un signal de détection, et est configuré pour dériver une valeur de mesure du champ cible de mesure sur la base du signal de détection ;
dans lequel le processeur est configuré pour effectuer un processus de filtrage numérique de suppression du bruit pour le signal CMR numérisé ou le signal de détection.

**2.** Procédé de mesure, comprenant les étapes de :

réalisation d'une opération quantique de spin électronique du membre de résonance magnétique (1) avec des micro-ondes et émission d'une lumière d'excitation vers le membre de résonance magnétique conformément à une séquence de mesure prédéterminée, le membre de résonance magnétique dont l'état quantique de spin électronique est modifié en fonction d'un champ cible de mesure et capable d'une opération quantique de spin électronique avec des micro-ondes ;
réception de la fluorescence émise par l'élément de résonance magnétique en fonction de la lumière d'excitation, et génération d'un signal de capteur de fluorescence correspondant à une intensité de fluorescence ;
réalisation de la réjection en mode commun du signal du capteur de fluorescence basée sur un signal de capteur de référence généré en recevant une lumière de référence obtenue comme une branche de la lumière d'excitation, et génération d'un signal CMR basé sur la réjection en mode commun ;
numérisation du signal CMR ;
numérisation d'un signal de capteur de lumière de référence généré par la réception d'une lumière de référence obtenue comme une branche de la lumière d'excitation ;
division du signal CMR numérisé par le signal numérisé du capteur de lumière de référence et génération, par conséquent, d'un signal de détection, suivi par déduction d'une valeur de mesure du champ cible de mesure sur la base de ce signal de détection ;
réalisation d'un processus de filtrage numérique de suppression du bruit pour le signal CMR numérisé ou le signal de détection.

**3.** Procédé de mesure selon la revendication 2, dans lequel le signal CMR est numérisé par un premier convertisseur analogique-numérique (26) ;

le signal du capteur de lumière de référence est numérisé par un second convertisseur analogique-numérique (27) ;
le premier convertisseur analogique-numérique fonctionne à une fréquence plus élevée que le second convertisseur analogique-numérique ; et
le second convertisseur analogique-numérique effectue une numérisation d'une précision supérieure à celle du premier convertisseur analogique-numérique.

**4.** Procédé de mesure selon la revendication 2, dans lequel le signal du capteur de lumière de référence numérisé et utilisé pour la génération de la lumière de détection est généré indépendamment du signal du capteur de lumière de référence utilisé pour la réjection en mode commun.

**5.** Procédé de mesure selon la revendication 2, dans lequel, dans le processus de filtrage numérique, une fonction de fenêtre est appliquée au signal CMR numérisé ou au signal de détection.

**6.** Procédé de mesure selon la revendication 2, comprenant en outre les étapes de :

(a) accumulation de valeurs du signal CMR numérisé obtenues plusieurs fois dans une première moitié d'une période d'irradiation de la lumière d'excitation et plusieurs fois dans une seconde moitié de la période d'irradia-

tion ; et

(b) calcul d’une différence entre une valeur d’accumulation du signal CMR dans la première moitié et une valeur d’accumulation du signal CMR dans la seconde moitié et, par conséquent, suppression d’une composante de bruit dans le signal CMR.

FIG. 1

12
EXCITATION LIGHT
22
24
ref2
27
ADC
21
23
MEASUREMENT TARGET
MAGNETIC FIELD
10
ref1
3
2
1
25
25a
STATIC
MAGNETIC
FIELD
FLUORESCENCE
ref1*α Init /β
CMR_SIG
+Vs
25b
26
11
13
PL
ADC
HIGH FREQUENCY
POWER SUPPLY
-Vs
PROCESSOR
31
41
42
43
MEASUREMENT
CONTROL UNIT
CALCULATION
UNIT
STORAGE
DEVICE

MEASUREMENT TARGET
AC MAGNETIC FIELD
(MAGNETIC FLUX DENSITY)
0
TIME
MICROWAVE
(AMPLITUDE)
0
TIME
EXCITATION LIGHT
(LASER LIGHT)
INITIALIZATION
MEASUREMENT
TIME
FLUORESCENCE
0
TIME

FIG. 2

FIG. 3
ref1(t), ref2(t)
MEASUREMENT
TIME
PL(t)
TIME
CMR_SIG(t)
0
TIME
SD(t)
0
TIME
$\frac{\alpha_{cont}(0)}{\beta}$
P1
P2
0
te

FIG. 4

TRANSMITTANCE
0
10
20
30
40
FREQUENCY (kHz)

FIG. 5

START
S1
STARTING
A MEASUREMENT SEQUENCE
S2
IRRADIATION OF MEASUREMENT LIGHT
DETECTION OF REFERENCE LIGHT
DETECTION OF FLUORESCENCE
S3
DERIVING A CMR SIGNAL
S4
DIGITIZATION OF THE REFERENCE LIGHT SENSOR SIGNAL
DIGITIZATION OF THE CMR SIGNAL
S5
APPLYING A WINDOW FUNCTION
TO THE CMR SIGNAL
S6
NOISE REMOVAL PROCESS
S7
DERIVING A DETECTION SIGNAL SD FROM THE CMR SIGNAL
WITH THE REFERENCE LIGHT SENSOR SIGNAL
S8
DERIVING A MEASUREMENT TARGET MAGNETIC FILED
(MAGNETIC FLUX DENSITY OR THE LIKE)
ON THE BASIS OF THE DETECTION SIGNAL SD
END

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019138772 A


### Non-patent literature cited in the description


- **JAMES L. WEBB**. Nanotesla sensitivity magnetic field sensing using a compact diamond nitrogen-vacancy magnetometer. *APPLIED PHYSICS LETTERS*, 10 June 2019, vol. 114 (23), ISSN 0003-6951